# EUROPÄISCHE PATENTSCHRIFT

(11) **EP 2 044 819 B1**
(45) Veröffentlichungstag und Bekanntmachung des Hinweises auf die Patenterteilung: **28.07.2010**
(21) Anmeldenummer: 07729103.7
(22) Anmeldetag: 14.05.2007
(51) Int. Cl.: H05K 3/28, H05K 3/00

(54) **VERFAHREN ZUM HERSTELLEN EINES FLEXIBLEN LEITERTRÄGERS UND ANORDNUNG MIT DEM FLEXIBLEN LEITERTRÄGER**
METHOD FOR PRODUCING A FLEXIBLE CONDUCTOR CARRIER AND ARRANGEMENT COMPRISING THE FLEXIBLE CONDUCTOR CARRIER
PROCEDE DE FABRICATION D'UN SUPPORT SOUPLE DE CONDUCTEUR ET ARRANGEMENT COMPRENANT LE SUPPORT SOUPLE DE CONDUCTEUR

(30) Priorität: 18.07.2006 DE 102006033269
(43) Veröffentlichungstag der Anmeldung: 08.04.2009
(73) Patentinhaber: Continental Automotive GmbH, 30165 Hannover (DE)
(72) Erfinder: FISCHER, Georg, 93051 Regensburg (DE); LOIBL, Josef, 93077 Bad Abbach (DE); SMIRRA, Karl, 83512 Wasserburg (DE)
(86) Internationale Anmeldenummer: PCT/EP2007/054651
(87) Internationale Veröffentlichungsnummer: WO 2008/009493

(56) Entgegenhaltungen:
- WO-A-2006/066983
- DE-C1- 10 100 823
- GB-A- 1 254 281
- US-A- 4 716 259
- US-A- 5 450 286
- US-B1- 6 300 566

## Beschreibung

In Kraftfahrzeugen werden regelmäßig elektronische Steuerelemente dezentralisiert angeordnet. Beispielsweise kann in einem Automatikgetriebe für Kraftfahrzeuge die entsprechende Steuerelektronik und die dazu gehörige Sensorik in das Getriebegehäuse des Automatikgetriebes eingebaut werden. Ähnliche Trends für eine "Vor-Ort-Elektronik" gibt es auch in anderen Bereichen der Kraftfahrzeuge, beispielsweise bei Motorsteuerungen und Bremssystemen. Aufgrund des geringen Bauraums eignen sich flexible Leiterträger besonders gut zur Verteilung von elektronischen Signalen und Strömen. Derartige Leiterträger bestehen regelmäßig aus zwei Polyimidfolien, zwischen denen leitende Kupferbahnen eingebettet sind.

Falls ein derartiger Leiterträger beispielsweise im Getriebegehäuse eingebaut ist, so müssen nicht isolierte Kontaktstellen des Leiterträgers gegenüber Partikeln im umgebenden Medium, beispielsweise Öl, abgedichtet werden. Ein Eindringen eines der Partikel in den Bereich der nicht isolierten Kontaktstelle des Leiterträgers kann zu einem Kurzschluss und somit zu einer Störung und/oder Beschädigung der Steuerelektronik führen, die den Leiterträger umfasst.

Die US 5,450,286 offenbart eine Anordnung mit gedruckten Schaltkreisen mit einer Basisplatte, einer flexiblen Leiterplatte, die mittels eines Haftmittels mit der Basisplatte verbunden ist, und einem Silikonüberzug, der auf ausgewählten Teilen der Oberfläche der flexiblen Leiterplatte aufgebracht ist.

Die DE 101 00 823 C1 offenbart einen dichten Elektronikraum für ein Motor- oder getriebeintegriertes Kraftfahrzeug-Steuergerät. Der Elektronikraum hat eine Trägerplatte, die eine wannenförmige Vertiefung aufweist, welche einen Aufnahmeraum für eine Steuerelektronik bildet, eine flexible Leiterplatte, die in einem die Vertiefung umlaufenden Bereich dicht auf die Trägerplatte aufgeklebt ist, über einen Rand der Vertiefung in diese hineingeführt ist und die dort angeordnete Steuerelektronik elektrisch kontaktiert, und eine Abdeckung, die über eine Verklebung mit der flexiblen Leiterplatte an der Trägerplatte befestigt ist und dabei die Vertiefung dicht verschließt.

Es ist Aufgabe der Erfindung, ein einfaches und kostengünstiges Verfahren zum Herstellen eines flexiblen Leiterträgers zu schaffen.

Die Aufgabe wird gelöst durch die Merkmale der unabhängigen Ansprüche. Vorteilhafte Ausgestaltungen der Erfindung sind in den Unteransprüchen angegeben.

Die Erfindung zeichnet sich gemäß eines ersten Aspekts der Erfindung durch ein Verfahren zum Herstellen eines ersten flexiblen Leiterträgers aus. Auf eine Basis-Isolierfolie wird zumindest eine Leiterbahn aufgebracht. Eine Deckschicht wird so auf die Leiterbahn und die Basis-Isolierfolie aufgebracht, dass in zumindest einem Leitungsbereich des ersten flexiblen Leiterträgers die Leiterbahn ganz von der Deckschicht und der Basis-Isolierfolie umschlossen ist, dass in zumindest einem Isolierbereich die Basis-Isolierfolie frei ist von der Leiterbahn und der Deckschicht und dass in zumindest einem Kontaktbereich des ersten flexiblen Leiterträgers die Leiterbahn frei ist von der Deckschicht. Die Deckschicht wird in zumindest einem Dichtbereich so aufgebracht, dass der erste flexible Leiterträger im Dichtbereich des ersten flexiblen Leiterträgers dieselbe Dicke aufweist wie im Leitungsbereich mit Leiterbahn.

Dies ermöglicht, lediglich im Bereich der Leiterbahnen die Deckschicht aufzubringen. Dies trägt dazu bei, Materialkosten für die Deckschicht zu sparen. Das Freilassen des Kontaktbereichs erübrigt weitere Verfahrensschritte zum Herstellen des Kontaktbereichs. Ferner kann auf ein Verkleben der Deckschicht, beispielsweise mit einem Acrylkleber, verzichtet werden. Dies trägt zu einem einfachen und kostengünstigen Herstellen des flexiblen Leiterträgers bei. Falls ein Teilbereich des flexiblen Leiterträgers dichtend von einem anderen Teilbereich des flexiblen Leiterträgers abgetrennt wird, so bilden sich keine Zwischenräume zwischen einem Dichtkörper zum Abtrennen des Teilbereichs und dem flexiblen Leiterträger im Dichtbereich. Der Dichtbereich trägt somit zu einem einfachen und besonders guten Abdichten der Teilbereiche voneinander bei.

In einer vorteilhaften Ausgestaltung des ersten Aspekts der Erfindung wird die Deckschicht mittels Siebdruckverfahren ausgebildet. Dies ermöglicht einfach und kostengünstig die Herstellung der Deckschicht.

Die Erfindung zeichnet sich gemäß eines zweiten Aspekts der Erfindung durch eine Anordnung mit dem ersten flexiblen Leiterträger aus. Ferner umfasst die Anordnung eine Basisplatte und einen Dichtkörper. Auf der Basisplatte ist die Basis-Isolierfolie so angeordnet, dass die Deckschicht von der Basisplatte abgewandt ist. Der Dichtkörper trennt einen Teilbereich, der den Kontaktbereich umfasst, des ersten flexiblen Leiterträgers gegenüber der Umgebung dichtend ab. Der Dichtkörper ist so ausgebildet und angeordnet, dass ein Rand des Dichtkörpers lediglich im Dichtbereich des ersten flexiblen Leiterträgers mit dem ersten flexiblen Leiterträger gekoppelt ist. Die Anordnung umfasst einen zweiten flexiblen Leiterträger, der entsprechend dem ersten flexiblen Leiterträger hergestellt wurde. Der zweite flexible Leiterträger ist neben dem ersten flexiblen Leiterträger auf der Basisplatte angeordnet. Der Dichtbereich erstreckt sich zumindest teilweise über die Basisplatte und den zweiten flexiblen Leiterträger, so dass die Deckschicht im Dichtbereich bezüglich der Basisplatte dieselbe Erhebung aufweist wie im Leitungsbereich.

Der Dichtbereich und die Kopplung des Dichtkörpers mit dem Dichtbereich tragen wirkungsvoll zu einem günstigen Abdichten des Teilbereichs gegenüber der Umgebung bei. Der Dichtbereich und die Kopplung des Dichtkörpers mit dem Dichtbereich über den ersten flexiblen Leiterträger hinaus tragen wirkungsvoll zu einem besonders günstigen Abdichten des Teilbereichs gegenüber der Umgebung bei.

In einer weiteren vorteilhaften Ausgestaltung des zweiten Aspekts der Erfindung ist zwischen dem Rand des Dichtkörpers und dem Dichtbereich eine Dichtung ausgebildet. Dies trägt einfach zu einem besonders guten Abdichten des Teilbereichs bei.

Die Erfindung ist im Folgenden anhand von schematischen Zeichnungen näher erläutert.

Es zeigen:
- Figur 1: einen flexiblen Leiterträger,
- Figur 2: einen Schnitt durch den flexiblen Leiterträger ge- mäß Figur 1,
- Figur 3: ein Ablaufdiagramm zum Herstellen des flexiblen Leiterträgers,
- Figur 4: der flexible Leiterträger auf einer Basisplatte,
- Figur 5: mehrere flexible Leiterträger auf der Basisplatte.

Elemente gleicher Konstruktion oder Funktion sind figurenübergreifend mit den gleichen Bezugszeichen gekennzeichnet.

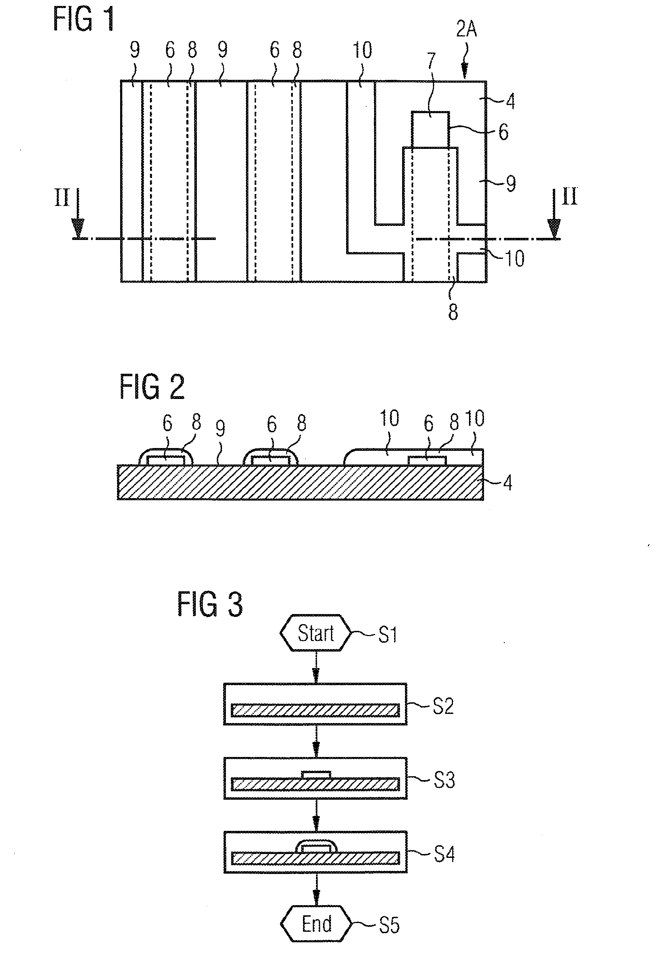

Ein erster flexibler Leiterträger 2A (Figur 1) umfasst eine Basis-Isolierfolie 4, zumindest eine, bevorzugt mehrere Leiterbahnen 6 und eine Deckschicht. Die Basis-Isolierfolie 4 umfasst vorzugsweise Polyimid. Die Leiterbahnen 6 umfassen vorzugsweise Kupfer. Die Deckschicht kann beispielsweise Fluor-Silikon umfassen.

Die Leiterbahnen 6 sind fest mit der Basis-Isolierfolie 4 verbunden. Die Deckschicht ist so auf die Basis-Isolierfolie 4 und die Leiterbahnen 6 aufgebracht, dass die Leiterbahnen 6 außerhalb zumindest eines Kontaktbereichs 7 vollständig von der Deckschicht und der Basis-Isolierfolie 4 umschlossen sind.

Ferner kann die Deckschicht in einem Dichtbereich 10 unabhängig von der Leiterbahn 6 auf die Basis-Isolierfolie 4 aufgebracht sein, damit im Dichtbereich 10 der erste flexible Leiterträger 2A dieselbe Dicke aufweist wie im Leitungsbereich 8 an der Leiterbahn 6 (Figur 2).

In einem Isolierbereich 9 weist der erste flexible Leiterträger 2A lediglich die Basis-Isolierfolie 4 auf. Der Isolierbereich 9 trennt die Leiterbahnen 6 isolierend voneinander ab. Das Fehlen der Deckschicht im Isolierbereich 9 trägt dazu bei, Material für die Deckschicht zu sparen. Dies trägt dazu bei, den ersten flexiblen Leiterträger besonders günstig herstellen zu können.

Ein Herstellungsprozess zum Herstellen des ersten flexiblen Leiterträgers 2A wird vorzugsweise in einem Schritt S1 gestartet (Figur 3). Im Schritt S1 können beispielsweise die Materialien und die Vorrichtungen zum Herstellen des ersten flexiblen Leiterträgers 2A vorbereitet werden.

In einem Schritt S2 wird die Basis-Isolierfolie 4 in einer der Vorrichtungen zum Herstellen des ersten flexiblem Leiterträgers 2A angeordnet und ausgerichtet.

In einem Schritt S3 werden die Leiterbahnen 6 auf die Basis-Isolierfolie aufgebracht. Beispielsweise kann ein Lage gewalztes Kupfer mit der Basis-Isolierfolie 4 verklebt werden. Die Leiterbahnen 6 können dann mittels eines Photobelichtungsprozesses und eines nachfolgenden Ätz-Verfahrens aus der Lage gewalzten Kupfers ausgebildet werden. Ferner kann der erste flexible Leiterträger 2A im Schritt S3 im Anschluss an das Ätz-Verfahren getrocknet und/oder gereinigt werden.

In einem Schritt S4 wird die Deckschicht aufgebracht. Die Deckschicht wird vorzugsweise mittels Siebdruckverfahren auf den ersten flexiblen Leiterträger 2A aufgebracht. Bei dem Siebdruckverfahren werden in einem Sieb die Maschen verschlossen in deren Bereich keine Deckschicht auf den flexiblen Leiterträger aufgebracht werden soll. Danach wird das Material der Deckschicht in zähflüssigem Zustand mittels eines Rakels durch das Sieb gedrückt. Das Siebdruckverfahren ermöglicht einfach im Leitungsbereich 8 und im Dichtbereich 10 dieselbe Dicke des ersten flexiblen Leiterträgers 2A herzustellen. Ferner können der Isolierbereich 9 und der Kontaktbereich 7 besonders einfach durch Verschließen der entsprechenden Maschen des Siebes ausgebildet werden.

Gegenüber einem bekannten Herstellungsprozess, bei dem anstatt der Deckschicht eine Deckfolie, beispielsweise eine Polyimid-Folie, auf den gesamten ersten flexiblen Leiterträger 2A aufgebracht wird, bietet der erfindungsgemäße Herstellungsprozess den Vorteil, dass lediglich im Leitungsbereich 8 und dem Dichtbereich 10 die Deckschicht aufgebracht wird. Dies spart gegenüber dem Aufbringen der Deckschicht auf den gesamten ersten flexiblen Leiterträger Material. Ferner müssen bei dem bekannten Herstellungsprozess nach dem Aufbringen der Deckfolie Ausnehmungen aus der Deckfolie ausgestanzt werden, damit die Leiterbahnen 6 kontaktiert werden können.

In einem Schritt S5 kann der Herstellungsprozess beendet werden. Alternativ dazu kann der erste flexible Leiterträger 2A auf einer Basisplatte 12 fest angeordnet werden. Beispielsweise kann der erste flexible Leiterträger 2A auf die Basisplatte 12 laminiert werden. Die Basisplatte 12 dient dazu, beim Betrieb des ersten flexiblen Leiterträgers 2A auftretende Wärme schnell abzuleiten. Daher umfasst die Basisplatte 12 vorzugsweise Aluminium.

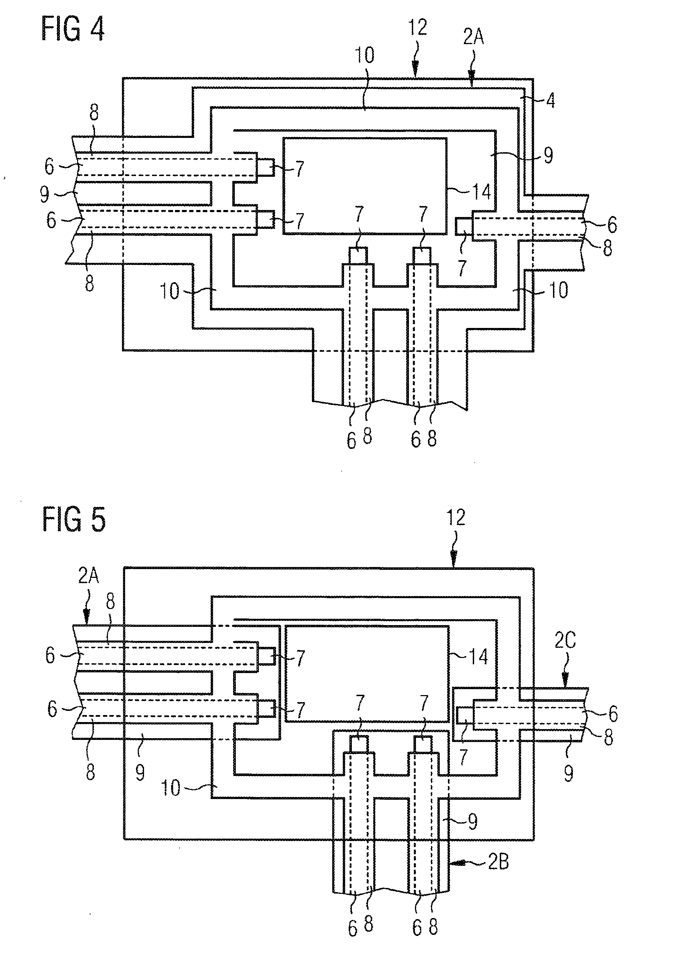

Eine Anordnung (Figur 4) mit dem ersten flexiblen Leiterträger 2A umfasst die Basisplatte 12. Die Basisplatte 12 kann eine Ausnehmung 14 der Basisplatte 12 zum Einbringen einer elektronischen Schaltung aufweisen. Der erste flexible Leiterträger 2A weist dann vorzugsweise in demselben Bereich ebenfalls eine Ausnehmung des ersten flexiblen Leiterträgers 2A auf. Der Dichtbereich 10 umschließt zusammen mit Teilbereichen des Leitungsbereichs 8 beispielsweise die Ausnehmung 14 der Basisplatte 12 und vorzugsweise die Kontaktbereiche 7 des ersten flexiblen Leiterträgers 2A. Nach Einbringen der elektronischen Schaltung in die Ausnehmung 14 der Basisplatte kann nun einfach ein Dichtkörper, beispielsweise ein Deckel, dessen Rand den gleichen Verlauf aufweist wie der Dichtbereich 10, auf die Anordnung gesetzt werden. Somit schließt der Dichtkörper mit seinem Rand den Teilbereich innerhalb des Dichtbereichs 10 dichtend gegenüber der Umgebung ab, ohne dass ein Spalt zwischen dem Rand des Dichtkörpers und dem Dichtbereich 10 entsteht.

Alternativ oder zusätzlich zum Dichtbereich 10 kann eine Dichtung zwischen dem Rand des Dichtkörpers und dem ersten flexiblen Leiterträger 2A angeordnet sein. Die Dichtung kann beispielsweise eine einfache Gummidichtung sein. Die Dichtung kann aber auch an den Rand des Dichtkörpers oder den ersten flexiblen Leiterträger 2A angespritzt werden, mit einem Dispensverfahren aufgebracht werden oder durch Aufbringen einer Kleberaupe, beispielsweise aus Fluor-Silikon, ausgebildet werden.

Alternativ oder zusätzlich können ein zweiter flexibler Leiterträger 2B und/oder ein dritter flexibler Leiterträger 2C an der Basisplatte 12 festgelegt sein (Figur 5). In diesem Zusammenhang ist es vorteilhaft, wenn die Deckschicht erst dann auf die flexiblen Leiterträger aufgebracht wird, wenn die Basis-Isolierfolie 4 der flexiblen Leiterträger auf die Basisplatte 12 aufgebracht ist und die Leiterbahnen 6 auf der Basis-Isolierfolie 4 aufgebracht sind. Die Deckschicht wird dann vorzugsweise so auf die Anordnung gebracht, dass sich der Dichtbereich auch außerhalb der flexiblen Leiterträger auf der Basisplatte 12 erstreckt. Vorzugsweise ist der Dichtbereich 10 außerhalb der flexiblen Leiterträger so auf der Basisplatte 12 aufgebracht, dass bezüglich der Basisplatte der Dichtbereich eine gleiche Erhebung aufweist wie in den Leitungsbereichen 8 der flexiblen Leiterträger. Dadurch wird die Bildung eines Spalts zwischen dem Rand des Dichtkörpers und dem Dichtbereich 10 vermieden. Dies trägt besonders einfach zu einem sehr günstigen und besonders dichten Anordnen der flexiblen Leiterträger bei.

Die Erfindung ist nicht auf die angegebenen Ausführungsbeispiele beschränkt. Beispielsweise können der Dichtbereich 10 und der Leitungsbereich 8 in demselben Arbeitsschritt mit der Deckschicht versehen werden. Alternativ dazu können der Leitungsbereich 8 und der Dichtbereich 10 nacheinander mit der Deckschicht gleichen oder unterschiedlichen Materials beschichtet werden. Ferner kann ein alternatives Verfahren zum Aufbringen der Deckschicht verwendet werden. Ferner können beliebig viele flexible Leiterträger mit beliebiger Form mit dem erfindungsgemäßen Herstellungsverfahren hergestellt werden. Ferner kann die Basisplatte 12 mit oder ohne Ausnehmung 14 der Basisplatte 12 hergestellt werden. Ferner können die Basis-Isolierfolie 4 und/oder die Deckschicht beliebige isolierende Materialien umfassen. Ferner können die Leiterbahnen 6 beliebige leitende Materialien umfassen. Ferner können die Verfahrensschritte des Verfahrens zum Herstellen der Leiterträger zumindest teilweise in einer anderen Reihenfolge abgearbeitet werden. Beispielsweise kann als erstes die Basis-Isolierfolie 4 auf die Basisplatte 12 aufgebracht werden. Danach können die Leiterbahnen 6 auf die Basis-Isolierfolie 4 aufgebracht werden.

## Patentansprüche

1. Verfahren zum Herstellen eines ersten flexiblen Leiterträgers (2A), bei dem auf eine Basis-Isolierfolie (4) zumindest eine Leiterbahn (6) aufgebracht wird und bei dem eine Deckschicht auf die Leiterbahn (6) und die Basis-Isolierfolie (4) so aufgebracht wird, dass
- in zumindest einem Leitungsbereich (8) des ersten flexiblen Leiterträgers (2A) die Leiterbahn (6) ganz von der Deckschicht und der Basis-Isolierfolie (4) umschlossen ist,
- in zumindest einem Isolierbereich (9) die Basis-Isolierfolie (4) frei ist von der Leiterbahn (6) und der Deckschicht,
- in zumindest einem Kontaktbereich (7) des ersten flexiblen Leiterträgers (2A) die Leiterbahn (6) frei ist von der Deckschicht, **dadurch gekennzeichnet, dass** in zumindest einem Dichtbereich (10) die Deckschicht so aufgebracht wird, dass der erste flexible Leiterträger (2A) im Dichtbereich (10) des ersten flexiblen Leiterträgers (2) dieselbe Dicke aufweist wie im Leitungsbereich (8) mit Leiterbahn (6).

2. Verfahren nach Anspruch 1, bei dem die Deckschicht mittels Siebdruckverfahren ausgebildet wird.

3. Anordnung mit
- dem ersten flexiblen Leiterträger (2A), der durch das Verfahren gemäß einem der vorstehenden Ansprüche hergestellt wird,
- einer Basisplatte (12) auf der die Basis-Isolierfolie (4) so angeordnet ist, dass die Deckschicht von der Basisplatte (12) abgewandt ist,
- einem Dichtkörper, der einen Teilbereich, der den Kontaktbereich (7) umfasst, des ersten flexiblen Leiterträgers (2A) gegenüber der Umgebung dichtend abtrennt und der so ausgebildet und angeordnet ist, dass ein Rand des Dichtkörpers lediglich im Dichtbereich (10) des ersten flexiblen Leiterträgers (2A) mit dem ersten flexiblen Leiterträger (2A) gekoppelt ist, **dadurch gekennzeichnet, dass**
die Anordnung einen zweiten flexiblen Leiterträger (2B) aufweist, der nach dem Verfahren gemäß einem der Ansprüche 1 bis 2 hergestellt wurde und der neben dem ersten flexiblen Leiterträger (2A) auf der Basisplatte (12) angeordnet ist, und mit dem Dichtbereich (10), der sich zumindest teilweise über die Basisplatte (12) und den zweiten flexiblen Leiterträger (2B) so erstreckt, dass die Deckschicht im Dichtbereich (10) bezüglich der Basisplatte (12) dieselbe Erhebung aufweist wie im Leitungsbereich (8).

4. Anordnung nach Anspruch 3, bei der zwischen dem Rand des Dichtkörpers und dem Dichtbereich (10) eine Dichtung ausgebildet ist.

## Claims

1. Method for producing a first flexible conductor carrier (2A), wherein at least one conductor track (6) is applied to a base insulating film (4) and wherein a covering layer is applied to the conductor track (6) and the base insulating film (4) such that
- in at least one conduction region (8) of the first flexible conductor carrier (2A) the conductor track (6) is completely enclosed by the covering layer and the base insulating film (4) ,
- in at least one insulating region (9) the base insulating film (4) is free of the conductor track (6) and the covering layer,
- in at least one contact region (7) of the first flexible conductor carrier (2A) the conductor track (6) is free of the covering layer,**characterised in that**
in at least one sealing region (10) the covering layer is applied such that the first flexible conductor carrier (2A) in the sealing region (10) of the first flexible conductor (2) carrier has the same thickness as in the conduction region (8) with conductor track (6).

2. Method according to claim 1, wherein the covering layer is formed using screen printing processes.

3. Arrangement having
- the first flexible conductor carrier (2A) which is produced by the method as claimed in one of the preceding claims,
- a baseplate (12) on which the base insulating film (4) is arranged such that the covering layer faces away from the baseplate (12),
- a sealing body which seals off a section, which includes the contact region (7), of the first flexible conductor carrier (2A) from the surroundings and which is formed and arranged such that an edge of the sealing body is connected to the first flexible conductor carrier (2A) only in the sealing region (10) of the first flexible conductor carrier (2A) **characterised in that**
the arrangement has a second flexible conductor carrier (2B), which was produced in accordance with the method according to one of claims 1 to 2 and which is arranged on the baseplate (12) next to the first flexible conductor carrier (2A), and having the sealing region (10) which extends at least partially over the baseplate (12) and the second flexible conductor carrier (2B) such that the covering layer has the same elevation in the sealing region (10) in respect of the baseplate (12) as in the conduction region (8).

4. Arrangement according to claim 3, wherein a seal is formed between the edge of the sealing body and the sealing region (10).

## Revendications

1. Procédé de fabrication d'un premier support de conducteurs (2A) flexible, dans lequel au moins une piste conductrice (6) est déposée sur un film isolant de base (4) et dans lequel une couche de protection est appliquée sur la piste conductrice (6) et le film isolant de base (4), de telle sorte que
- dans au moins une zone de conduction (8) du premier support de conducteurs (2A) flexible, la piste conductrice (6) est entièrement enveloppée par la couche de protection et le film isolant de base (4),
- dans au moins une zone d'isolation (9), le film isolant de base (4) n'est couvert ni par la piste conductrice (6) ni par la couche de protection,
- dans au moins une zone de contact (7) du premier support de conducteurs (2A) flexible, la piste conductrice (6) n'est pas couverte par la couche de protection,
**caractérisé en ce que** dans au moins une zone étanche (10), la couche de protection est appliquée de telle sorte que le premier support de conducteurs (2A) flexible possède dans la zone étanche (10) du premier support de conducteurs (2) flexible la même épaisseur que dans la zone de conduction (8) avec piste conductrice (6).

2. Procédé selon la revendication 1, dans lequel la couche de protection est réalisée au moyen d'un procédé de sérigraphie.

3. Arrangement comportant
- le premier support de conducteurs (2A) flexible, qui est fabriqué par le procédé selon l'une des revendications précédentes,
- une plaque de base (12), sur laquelle le film isolant de base (4) est agencé de telle sorte que la couche de protection est détournée de la plaque de base (12),
- un corps d'étanchéité, qui forme une séparation étanche entre une zone partielle, comportant la zone de contact (7), du premier support de conducteurs (2A) flexible et l'environnement et qui est réalisé et disposé de telle sorte qu'un bord du corps d'étanchéité est couplé au premier support de conducteurs (2A) flexible uniquement dans la zone étanche (10) du premier support de conducteurs (2A) flexible,
**caractérisé en ce que** l'arrangement comporte un deuxième support de conducteurs (2B) flexible qui a été fabriqué par le procédé selon l'une des revendications 1 à 2 et qui est agencé à côté du premier support de conducteurs (2A) flexible sur la plaque de base (12), et comporte la zone d'étanchéité (10), qui s'étend au moins partiellement sur la plaque de base (12) et le deuxième support de conducteurs (2B) flexible, de telle sorte que la couche de protection possède dans la zone d'étanchéité (10) par rapport à la plaque de base (12) la même hauteur que dans la zone de conduction (8).

4. Arrangement selon la revendication 3, dans lequel une étanchéité est réalisée entre le bord du corps d'étanchéité et la zone étanche (10).
